# EUROPÄISCHE PATENTSCHRIFT

(11) **EP 3 978 306 B1**
(45) Veröffentlichungstag und Bekanntmachung des Hinweises auf die Patenterteilung: **09.12.2026**
(21) Anmeldenummer: 21198007.3
(22) Anmeldetag: 21.09.2021
(51) Int. Cl.: B60L 58/16, B60L 53/62, B60L 53/68, G01R 31/367, G01R 31/382, G01R 31/00

(54) **VERFAHREN UND VORRICHTUNG ZUR MASCHINENINDIVIDUELLEN VERBESSERUNG DER LEBENSDAUER EINER BATTERIE IN EINER BATTERIEBETRIEBENEN MASCHINE**
METHOD AND APPARATUS FOR IMPROVING THE SERVICE LIFE OF A BATTERY IN A BATTERY OPERATED MACHINE
PROCÉDÉ ET DISPOSITIF D'AMÉLIORATION SPÉCIFIQUE À UNE MACHINE DE LA DURÉE DE VIE D'UNE BATTERIE DANS UNE MACHINE FONCTIONNANT SUR BATTERIE

(30) Priorität: 29.09.2020 DE 102020212278
(43) Veröffentlichungstag der Anmeldung: 06.04.2022
(73) Patentinhaber: Robert Bosch GmbH, 70442 Stuttgart (DE)
(72) Erfinder: Simonis, Christian, 71229 Leonberg (DE); Woll, Christoph, 70839 Gerlingen (DE)

(56) Entgegenhaltungen:
- EP-A1- 2 133 706
- EP-A1- 2 631 663
- DE-A1- 102005 050 563
- DE-A1- 102009 024 422
- DE-A1- 102011 005 711
- DE-A1- 102013 203 661
- DE-A1- 102014 212 451
- DE-A1- 102015 001 050
- DE-A1- 102016 211 898
- DE-A1- 102018 220 494
- DE-B3- 102019 107 426
- US-A1- 2015 171 640

## Beschreibung

### Technisches Gebiet

Die Erfindung betrifft batteriebetriebene Maschinen, insbesondere Elektrofahrzeuge oder Hybridfahrzeuge, und weiterhin Management-Verfahren und -Systeme mit Funktionen zum Verlängern einer Lebensdauer einer Batterie.

### Technischer Hintergrund

Die Energieversorgung von batteriebetriebenen Maschinen erfolgt mithilfe eines elektrischen Energiespeichers, in der Regel mit einer Batterie. Der Alterungszustand der Batterie ändert sich im Laufe ihrer Lebensdauer zusehends, was sich in einer abnehmenden Speicherkapazität auswirkt. Ein Maß der Alterung hängt von Stressfaktoren ab, die sich aus der Art der Nutzung der Batterie ergeben. Die individuelle Belastung der Batterie hängt vom Maschinentyp und/oder vom Nutzungsverhalten eines Nutzers ab und hat entsprechend maschinenindividuellen Einfluss auf den Verlauf des Alterungszustands.

Eine für den Nutzer interessante Größe ist die Restlebensdauer der Batterie, die aus dem aktuellen Alterungszustand bestimmt werden kann. Diese Angabe ermöglicht diesem, einen Austausch der Batterie längerfristig zu planen.

Weiterhin wird von Herstellern zwar eine Lebensdauergarantie für Batterien angegeben, diese kann jedoch durch entsprechend stressende Nutzung der Batterie ggfs. nicht eingehalten werden.

Die Druckschrift EP 2 631 663 A1 offenbart ein Verfahren zur kontinuierlichen Überwachung einer Batteriealterung, wobei die Batteriealterung auf Basis eines Batteriestroms quantitativ beschrieben wird, wobei eine ermittelte Alterungszahl direkt Aufschluss über die Batteriealterung sowie einen eventuell notwendigen Austausch der Batterie gibt.

Es ist daher erwünscht, Einfluss auf die Nutzung der Batterie zu nehmen, um deren Lebensdauer zu erhöhen, wenn besondere Stressfaktoren erkennbar sind oder wenn ggfs. eine Nicht-Einhaltung der Lebensdauergarantie absehbar ist.

### Offenbarung der Erfindung

Erfindungsgemäß sind ein Verfahren zum Betreiben eines Systems mit einer batteriebetriebenen Maschine mit einer Batterie und zum Bereitstellen einer Maßnahme zur maschinenindividuellen Verlängerung der Lebensdauer der Batterie einer Maschine gemäß Anspruch 1 sowie eine Vorrichtung und ein System mit einer Zentraleinheit und einer Vielzahl von Maschinen gemäß den nebengeordneten Ansprüchen vorgesehen.

Weitere Ausgestaltungen sind in den abhängigen Ansprüchen angegeben.

Gemäß einem ersten Aspekt ist ein computerimplementiertes Verfahren zum Betreiben eines Systems mit einer batteriebetriebenen Maschine mit einer Batterie vorgesehen, mit folgenden Schritten:
- kontinuierliches Bereitstellen von Betriebsgrößen der Batterie;
- Ermitteln von Betriebsmerkmalen oder Nutzmustern für einen aktuellen Auswertungszeitraum abhängig von den Verläufen der bereitgestellten Betriebsgrößen, wobei die Betriebsmerkmale eine Nutzung der Batterie in dem Auswertungszeitraum charakterisieren;
- Ermitteln eines oder mehrerer stressmaximierender Betriebsmerkmale oder Nutzmuster, die einem Stressfaktor für die Batterie zugeordnet sind, der/das den stärksten Einfluss auf die Alterung der Batterie hat, mithilfe eines Alterungszustandsmodells;
- Signalisieren einer Maßnahme in der Maschine abhängig von dem ermittelten Stressfaktor.

Der Alterungszustand einer Batterie, wird üblicherweise nicht direkt gemessen. Dies würde eine Reihe von Sensoren in der Batterie erfordern, die die Herstellung einer solchen Batterie aufwendig machen und den Raumbedarf vergrößern würden. Zudem sind automotive-taugliche Verfahren zur Alterungszustandsbestimmung in der Maschine noch nicht für den Realbetrieb verfügbar. Daher wird der aktuelle Alterungszustand in der Regel mithilfe eines physikalischen oder empirischen Alterungsmodells in der Maschine ermittelt. Dieses physikalische Alterungszustandsmodell weist Worst Case Modellabweichungen von mehr als 5 % auf. Aufgrund der Ungenauigkeit des physikalischen Alterungsmodells kann dieses zudem lediglich den momentanen Alterungszustand der Batterie angeben. Eine Prädiktion des Alterungszustands, die insbesondere von der Betriebsweise der Batterie, wie z. B. von der Höhe und Menge des Ladungszuflusses und Ladungsabflusses, und damit von einem Betriebsverhalten und von Maschinenparametern abhängt, würde zu sehr ungenauen Vorhersagen führen und ist derzeit nicht in der Maschine vorgesehen.

Der Alterungszustand (SOH: state of health) ist die Schlüsselgröße zur Angabe einer verbleibenden Batteriekapazität oder verbleibende Batterieladung. Der Alterungszustand kann als Kapazitätserhaltungsrate (capacity retention rate, SOH-C) oder als Anstieg des Innenwiderstands (SOH-R) angegeben werden. Die Kapazitätserhaltungsrate SOH-C ist als Verhältnis der gemessenen momentanen Kapazität zu einer Anfangskapazität der vollständig aufgeladenen Batterie angegeben. Die relative Änderung des Innenwiderstands SOH-R steigt mit zunehmender Alterung der Batterie an.

Das obige Verfahren nutzt eine nutzer- und maschinenindividuelle Prädiktion eines Alterungszustands des elektrischen Energiespeichers basierend auf einem datenbasierten oder hybriden (physikalisch + datenbasiert) Alterungszustandsmodell in einer Zentraleinheit. Dieses Alterungszustandsmodell kann mithilfe von ausgewerteten Flottendaten erstellt werden.

Das obige Verfahren sieht vor, abhängig von einem nutzerindividuellen Betrieb der Maschine Stressfaktoren zu ermitteln, die den größten Einfluss auf die Alterung der Batterie haben. Dadurch ist es möglich, abhängig von den Stressfaktoren Maßnahmen zu ermitteln, durch die die Alterung der Batterie bestmöglich verlangsamt werden kann, um so die Restlebensdauer der Batterie mit möglichst geringen und damit für den Nutzer akzeptableren Beschränkungen zu verlängern.

Stressfaktoren im Sinne dieser Beschreibung stressen die Batterie und lassen sie verstärkt altern. Betriebsmerkmale bestimmen Nutzmuster, die ein typisches maschinenindividuelles Verhalten, z. B. häufiges Schnellladen am Morgen, darstellen. Stressfaktoren werden aus den Nutzmustern abgeleitet, also in dem Beispiel: Hohe Ströme bei niedrigen Temperaturen, was zu LI-Plating und somit zur Alterung führt. Stressfaktoren beruhen also auf bekannten Wirkketten zur Alterung.

Grundsätzlich ist es möglich, durch eine Prädiktion des Alterungszustands der Batterie, insbesondere mit Hilfe eines geeigneten auf Flottendaten basierenden datenbasierten Alterungszustandsmodells, zu bestimmen, wann ein Zielwert des Alterungszustands bzw. eine Restlebensdauer von null erreicht wird. Dies kann einem Nutzer signalisiert werden, um diesen zu veranlassen, die Batterie auszutauschen. Auch ist die Angabe über die Restlebensdauer hilfereich, um festzustellen, ob eine garantierte Gesamtlebensdauer der Batterie entsprechend den Herstellerangaben eingehalten wird.

Insbesondere besteht eine Schwierigkeit darin, eine Garantie für eine Lebensdauer einer Batterie vorzugeben, ohne dass nutzerindividuelle Stressfaktoren berücksichtigt werden. So können Nutzer durch unterschiedliches Nutzungs- die Batterie mehr oder weniger stressen, wodurch die Alterung der Batterie maßgeblich beeinträchtigt wird. Eine vorgegebene Garantie, wie beispielsweise ein Abfall des Alterungszustands auf 80 % der Kapazität zum Einbauzeitpunkt innerhalb eines bestimmten Zeitraums, von z. B. acht Jahren, kann so nur unter Vorbehalten gegeben werden.

Das obige Verfahren ermöglicht durch das Bereitstellen von bestimmten Maßnahmen, die Lebensdauer der Batterie zu verlängern. Insbesondere kann einem Nutzer eine geeignete Maßnahme zum Verlängern der Lebensdauer der Batterie vorgeschlagen werden. Zudem besteht eine Möglichkeit, die Garantiezusage für eine Batterie an das Einhalten der Maßnahmenvorschläge zu binden.

Die Maßnahmenvorschläge werden unter Berücksichtigung der typischen Nutzmuster des Nutzers entsprechend einer Auswahl des- bzw. derjenigen Stressfaktors vorgeschlagen, dessen Änderung den größten Einfluss auf die Änderung des Alterungszustands haben kann. Dies ermöglicht so einen schonenden Eingriff in die Nutzungsgewohnheiten des Nutzers, da sich die Maßnahmen lediglich auf einen oder wenige Aspekte der Nutzmuster bzw. Nutzungsgewohnheiten des Nutzers beziehen. Somit kann eine besonders gute Akzeptanz der vorgeschlagenen Maßnahmen erreicht werden.

Die typischen Nutzmuster werden über eine Flottenanalyse abgeleitet und bewertet. Das Ermitteln des einen oder der mehreren stressmaximierenden Betriebsmerkmale wird maschinenextern in einer Zentraleinheit durchgeführt, in der das Alterungszustandsmodell implementiert ist, das insbesondere basierend auf Flottendaten einer Vielzahl von Maschinen erstellt ist.

Weiterhin kann ein Zielwert für das eine oder die mehreren stressmaximierenden Betriebsmerkmale als ein Wert für das eine oder die mehreren stressmaximierenden Betriebsmerkmale ermittelt werden, bei dem bei ansonsten gleichbleibendem Verlauf der Betriebsmerkmale die Alterung der Batterie gerade noch das Erreichen einer vorgegebenen Mindestlebensdauer der Batterie gewährleistet.

Insbesondere kann die zu signalisierende Maßnahme abhängig von dem ermittelten einen oder den mehreren stressmaximierenden Betriebsmerkmalen und dem jeweiligen Zielwert des einen oder den mehreren stressmaximierenden Betriebsmerkmalen zugeordnet werden.

Es kann vorgesehen sein, dass das Ermitteln des einen oder der mehreren stressmaximierenden Betriebsmerkmale nur diejenigen Betriebsmerkmale berücksichtigt, die Maßnahmen aus einer Akzeptanzmenge von Maßnahmen zugeordnet sind, wobei signalisierte Maßnahmen, die einmalig oder mehrmalig nicht von einem Nutzer umgesetzt worden sind, aus der Akzeptanzmenge von Maßnahmen entfernt werden.

Weiterhin kann das Ermitteln des einen oder der mehreren stressmaximierenden Betriebsmerkmale durchgeführt werden, indem mithilfe des Alterungszustandsmodells ein normierter Gradient des Alterungszustands über den Betriebsmerkmalen ermittelt wird, wobei dasjenige bzw. diejenigen Betriebsmerkmale als stressmaximierende Betriebsmerkmale ausgewählt werden, für die der normierte Gradient am höchsten ist.

Weiterhin können die Betriebsgrößen der Batterie einer bestimmten Maschine an eine maschinenexterne Zentraleinheit übermittelt werden, wobei die Schritte des Ermittelns von Betriebsmerkmalen für einen aktuellen Auswertungszeitraum und des Ermittelns des einen oder der mehreren stressmaximierenden Betriebsmerkmale in der Zentraleinheit ausgeführt werden, wobei das eine oder die mehreren stressmaximierenden Betriebsmerkmale an die bestimmte Maschine übermittelt werden
Gemäß einem weiteren Aspekt ist eine Vorrichtung zum Betreiben einer batteriebetriebenen Maschine mit einer Batterie vorgesehen, wobei die Vorrichtung ausgebildet ist zum:
- kontinuierliches Bereitstellen von Betriebsgrößen der Batterie;
- Ermitteln von Betriebsmerkmalen für einen aktuellen Auswertungszeitraum abhängig von den Verläufen der bereitgestellten Betriebsgrößen, wobei die Betriebsmerkmale eine Nutzung der Batterie in dem Auswertungszeitraum charakterisieren;
- Ermitteln eines oder mehrerer stressmaximierender Betriebsmerkmale, die einem Stressfaktor für die Batterie zugeordnet sind, der den stärksten Einfluss auf die Alterung der Batterie hat, mithilfe eines Alterungszustandsmodells;
- Signalisieren einer Maßnahme in der Maschine abhängig von dem ermittelten Stressfaktor.

Gemäß einem weiteren Aspekt ist ein System mit einer Zentraleinheit und einer Vielzahl von Maschinen vorgesehen, wobei jede Maschine die obige Vorrichtung umfasst.

Es kann vorgesehen sein, dass die Zentraleinheit ausgebildet ist, um das Ermitteln von Betriebsmerkmalen und das Ermitteln des einen oder der mehreren stressmaximierenden Betriebsmerkmale auszuführen.

### Kurzbeschreibung der Zeichnungen

Ausführungsformen werden nachfolgend anhand der beigefügten Zeichnungen näher erläutert. Es zeigen:
- Figur 1: eine schematische Darstellung eines Systems zum Bereitstellen von fahrer- und fahrzeugindividuellen Belastungsgrößen für eine Fahrzeugbatterie basierend auf Flottendaten;
- Figur 2: eine schematische Darstellung eines funktionalen Aufbaus eines hybriden Alterungszustandsmodells;
- Figur 3: ein Flussdiagramm zur Veranschaulichung eines Verfahrens zum Signalisieren einer Maßnahme für den Betrieb eines Kraftfahrzeugs; und
- Figur 4: eine Darstellung für die Verläufe des Alterungszustands bei unterschiedlichen Häufigkeiten von Schnellladezyklen zur Bestimmung der Maßnahmen zur Verlängerung der Lebensdauer der Fahrzeugbatterie bei gleichzeitiger Optimierung der Fahrerakzeptanz.

### Beschreibung von Ausführungsformen

Im Folgenden wird das erfindungsgemäße Verfahren anhand von Fahrzeugbatterien als Batterien in einer Vielzahl von Kraftfahrzeugen als batteriebetriebene Maschinen beschrieben. In den Kraftfahrzeugen kann in einer Steuereinheit ein datenbasiertes Alterungszustandsmodell für die jeweilige Fahrzeugbatterie implementiert sein. Das Alterungszustandsmodell kann in einer Zentraleinheit kontinuierlich basierend auf Betriebsgrößen der Fahrzeugbatterien aus der Fahrzeugflotte aktualisiert bzw. nachtrainiert werden.

Das obige Beispiel steht stellvertretend für eine Vielzahl von stationären oder mobilen batteriebetriebenen Maschinen und Geräte mit netzunabhängiger Energieversorgung, wie beispielsweise Fahrzeuge (Elektrofahrzeuge, Pedelecs usw.), Anlagen, Werkzeugmaschinen, Haushaltsgeräte, IOT-Geräte, eine Gebäudeenergieversorgungen, Fluggeräte, insbesondere Drohnen, autonome Roboter und Geräte der Unterhaltungselektronik, insbesondere Mobiltelefone, und dergleichen, die über eine entsprechende Kommunikationsverbindung (z. B. LAN, Internet) mit einer Zentraleinheit (Cloud) in Verbindung stehen.

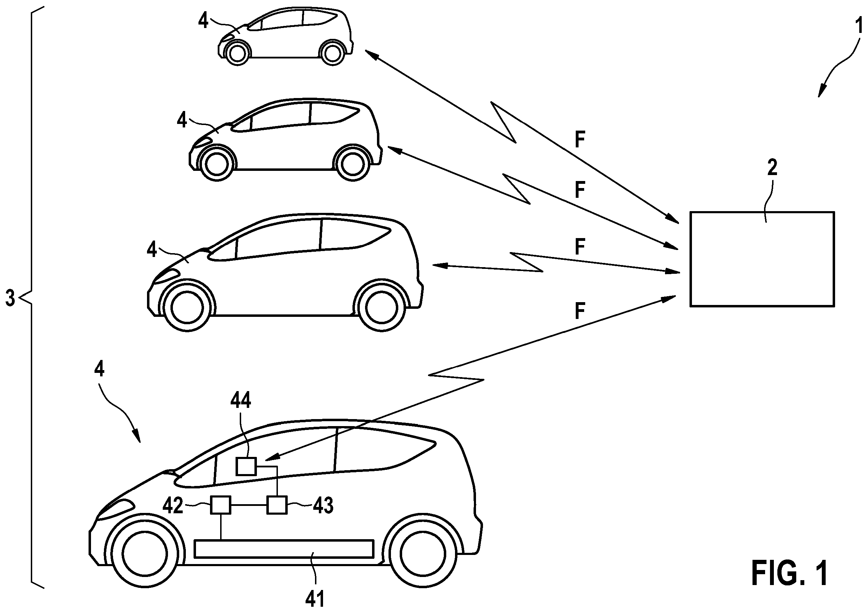

Figur 1 zeigt ein System 1 zum Sammeln von Flottendaten in einer Zentraleinheit 2 zur Erstellung eines Alterungszustandsmodells. Das Alterungszustandsmodell dient zur Bestimmung eines Alterungszustands eines elektrischen Energiespeichers in einem Kraftfahrzeug. Figur 1 zeigt eine Fahrzeugflotte 3 mit mehreren Kraftfahrzeugen 4.

Eines der Kraftfahrzeuge 4 ist in Figur 1 detaillierter dargestellt. Die Kraftfahrzeuge 4 weisen jeweils eine Fahrzeugbatterie 41 als wiederaufladbaren elektrischen Energiespeicher, einen elektrischen Antriebsmotor 42 und eine Steuereinheit 43 auf. Die Steuereinheit 43 ist mit einem Kommunikationsmodul 44 verbunden, das geeignet ist, Daten zwischen dem jeweiligen Kraftfahrzeug 4 und einer Zentraleinheit (einer sogenannten Cloud) zu übertragen.

Die Kraftfahrzeuge 4 senden an die Zentraleinheit 2 die Betriebsgrößen F, die zumindest Größen angeben, von denen der Alterungszustand der Fahrzeugbatterie abhängt. Die Betriebsgrößen F können im Falle einer Fahrzeugbatterie einen momentanen Batteriestrom, eine momentane Batteriespannung, eine momentane Batterietemperatur und einen momentanen Ladezustand (SOC: State of Charge) angeben, sowohl auch Pack-, Modul- und / oder Zellebene. Die Betriebsgrößen F werden in einem schnellen Zeitraster von 2 Hz bis 100 Hz erfasst und können in unkomprimierter und/oder komprimierter Form regelmäßig an die Zentraleinheit 2 übertragen werden. Beispielsweise können die Zeitreihen im Abstand von 10 min bis mehreren Stunden blockweise an die Zentraleinheit 2 übertragen werden.

Aus den Betriebsgrößen F können in der Zentraleinheit 2 oder in anderen Ausführungsformen auch bereits in den jeweiligen Kraftfahrzeugen 4 Betriebsmerkmale generiert werden, die sich auf einen Auswertungszeitraum beziehen. Der Auswertungszeitraum kann für die Bestimmung des Alterungszustands wenige Stunden (z. B. 6 Stunden) bis mehrere Wochen (z. B. einen Monat) betragen. Ein üblicher Wert für den Auswertungszeitraum beträgt eine Woche.

Die Betriebsmerkmale können beispielsweise auf den Auswertungszeitraum bezogene Merkmale und/oder akkumulierte Merkmale und/oder über die gesamte bisherige Lebensdauer ermittelte statistische Größen umfassen. Insbesondere können die Betriebsmerkmale beispielsweise umfassen: Elektrochemische Zustände (Schichtdicken, Konzentrationen, zyklisierbares Lithium, ...), Histogrammdaten über dem Ladezustandsverlauf, der Temperatur, der Batteriespannung, des Batteriestroms, insbesondere Histogrammdaten bezüglich der Batterietemperaturverteilung über dem Ladezustand, der Ladestromverteilung über der Temperatur und/oder der Entladestromverteilung über der Temperatur, akkumulierte Gesamtladung (Ah), eine durchschnittliche Kapazitätszunahme bei einem Ladevorgang (insbesondere für Ladevorgänge, bei denen die Ladungszunahme über einem Schwellenanteil (z. B. 20 %) der gesamten Batteriekapazität liegt), ein Maximum der differentiellen Kapazität (dQ/dU: Ladungsänderung dividiert durch Änderung der Batteriespannung) und weitere.

Aus dem individuellen Betriebsmerkmal, das ein Betriebsverhalten eines Fahrers charakterisiert, lassen sich weitere Angaben entnehmen: ein zeitliches Belastungsmuster wie Lade- und Fahrzyklen, bestimmt durch Nutzungsmuster (wie bspw. Schnellladen bei hohen Stromstärken oder starke Beschleunigung bzw. Bremsvorgänge mit Rekuperation), eine Nutzungszeit der Fahrzeugbatterie, eine über die Laufzeit kumulierte Ladung und eine über die Laufzeit kumulierte Entladung, einen maximalen Ladestrom, einen maximalen Entladestrom, eine Ladehäufigkeit, einen durchschnittlichen Ladestrom, einen durchschnittlichen Entladestrom, einen Leistungsdurchsatz beim Laden und Entladen, eine (insbesondere durchschnittliche) Ladetemperatur, eine (insbesondere durchschnittliche) Spreizung des Ladezustandes und dergleichen.

Die Betriebsgrößen sind so angegeben, dass diese durch bekannte datenbasierte Extrapolationsverfahren (wie autoregressive Modelle, z. B. ARMA oder ARIMA-Modellen), welche Trends und Periodizitäten in Lasten modellieren, zu zukünftigen Zeitpunkten fortgeschrieben werden können und dadurch zur Prädiktion eines prädizierten Alterungszustands verwendet werden können.

Zusätzlich können als Teil der Betriebsgrößen Umgebungsgrößen an die Zentraleinheit 2 gesendet oder dort erfasst oder ermittelt werden, wobei die Umgebungsgrößen Angaben über das Umfeld und/oder eine Verkehrs- und/oder Wettersituation der Umgebung des Kraftfahrzeugs 4 angeben. Die Umgebungsgrößen können einen oder mehrere der folgenden Größen umfassen: Verkehrsdaten, Angaben über das Verkehrsaufkommen auf einer prädizierten Fahrstrecke, Wetterdaten sowie den Standort des Kraftfahrzeugs.

In der Zentraleinheit 2 kann ein Alterungszustandsmodell implementiert sein, das insbesondere datenbasiert ist, oder als hybrides Alterungszustandsmodell mit einem physikalischen Modell und einem datenbasierten Korrekturmodell ausgebildet ist. Das Alterungszustandsmodell kann regelmäßig, d. h. nach Ablauf der jeweiligen Auswertungszeitdauer, verwendet werden, um basierend auf den Betriebsgrößen und/oder den Betriebsmerkmalen eine Ermittlung des momentanen Alterungszustands der Fahrzeugbatterie 41 vorzunehmen. Mit anderen Worten ist es möglich, basierend auf den Betriebsmerkmalen, die sich aus den Betriebsgrößenverläufen eines der Kraftfahrzeuge 4 der Flotte 3 ergeben, einen Alterungszustand der betreffenden Fahrzeugbatterie 41 zu ermitteln.

Weiterhin können Betriebsmerkmale, beispielsweise durch lineare oder nichtlineare Extrapolation oder mithilfe eines Prädiktionsmodells, künftige Alterungszustände der Fahrzeugbatterie 41 ermittelt werden. Auch können die Betriebsgrößen, d. h. Verläufe des Batteriestroms, der Batteriespannung, des Ladezustands und der Batterietemperatur als Eingangsgrößen für das Prädiktionsmodell verwendet werden und entsprechend extrapoliert werden.

Ferner können aus den Betriebsmerkmalen Stressfaktoren für den Auswertungszeitraum identifiziert werden, die jeweils eine besondere Belastung der Fahrzeugbatterie bewirken, wie beispielsweise die Anzahl der Schnellladezyklen, hohe Entladeströme aufgrund hoher Fahrzeugbeschleunigung oder hohen Fahrzeuggeschwindigkeiten, eine hohe Strombelastung bei tiefen und hohen Temperaturen, ein häufiges Entladen bis an die Entladeschlussspannung (tiefe SoC von bspw. 20 %) und andere eine hohe Belastung darstellende Stressfaktoren, die eine schnelle Alterung der Fahrzeugbatterie 41 verursachen können.

Das Alterungszustandsmodell in der Zentraleinheit 2 kann basierend auf detaillierten Vermessungen von Fahrzeugbatterien 41 der Fahrzeuge 4 in der Flotte 3 trainiert werden. Dazu werden Trainingsdaten für das Alterungszustandsmodell durch eine Bestimmung des tatsächlichen Alterungszustands einer jeweiligen Fahrzeugbatterie 41 erfolgen. Beispielsweise kann die Kapazitätserhaltungsrate (SOH-C) durch eine Messung der gesamten Ladungsaufnahme einer Batterie während eines Ladezyklus von einem vollständig entladenen Zustand zu einem vollständig geladenen Zustand bestimmt werden. Somit steht in der Zentraleinheit 2 ein datenbasiertes Alterungsmodell zur Verfügung, das sich zur Ermittlung des tatsächlichen Alterungszustands einer Fahrzeugbatterie 41 eines sich in der Flotte 3 befindlichen Kraftfahrzeugs 4 und zur Prädiktion von Alterungszuständen durch Fortschreiben von Betriebsmerkmalen in künftige Auswertungszeiträume eignet.

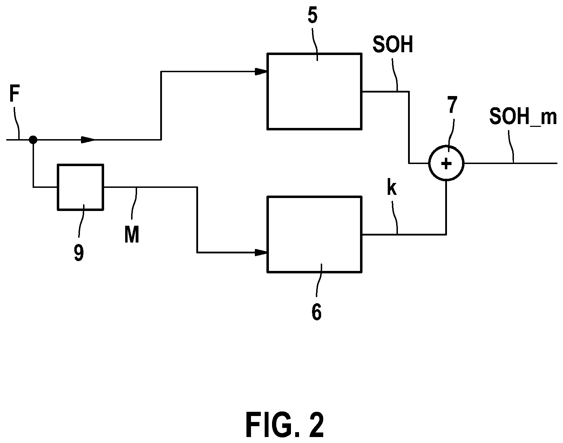

Figur 2 zeigt beispielhaft schematisch den funktionalen Aufbau einer Ausführungsform eines datenbasierten Alterungszustandsmodells 9, das in einer hybriden Weise aufgebaut ist. Das Alterungszustandsmodell 9 umfasst ein physikalisches Alterungsmodell 5 und ein Korrekturmodell 6. Diese erhalten Betriebsmerkmale M eines aktuellen Auswertungszeitraums von einem Merkmalsextraktionsblock 8 basierend auf den Zeitreihen der Betriebsgrößen F. Alternativ können die Betriebsgrößen F auch direkt in das physikalische Alterungszustandsmodell 5 eingehen, welches vorzugsweise als elektrochemisches Modell ausgeführt ist und entsprechende elektrochemische Zustände, wie Schichtdicken der Aktivmaterialien, Änderung des zyklisierbaren Lithiums aufgrund von Anode/Kathode-Nebenreaktionen, Aufbau der Solid Electrolyte Interface (SEI-Grenzschicht) langsamer Verbrauch von Elektrolyten, Verlust des Aktivmaterials der Anode, Verlust des Aktivmaterials der Kathode, etc....), usw. mithilfe von nichtlinearen Differentialgleichungen beschreibt.

Das physikalische Alterungsmodell 5 entspricht einem elektrochemischen Modell der Batteriezelle und der Zellchemie. Dieses Modell ermittelt abhängig von den Betriebsmerkmalen M interne physikalische Batteriezustände, um einen physikalisch basierten Alterungszustand in Form einer Kapazitätserhaltungsrate (SOH-C) und/oder als Innenwiderstandanstiegsrate (SOH-R) bereitzustellen.

Die durch das elektrochemische Modell bereitgestellten Modellwerte für den Alterungszustand SOH sind jedoch in bestimmten Situationen ungenau, und es ist daher vorgesehen, diese mit einer Korrekturgröße k zu korrigieren. Die Korrekturgröße k wird von dem datenbasierten Korrekturmodell 6 bereitgestellt, das mithilfe von Trainingsdatensätzen aus den Fahrzeugen 4 der Fahrzeugflotte 3 trainiert wird.

Für die Bestimmung eines korrigierten Alterungszustands SOH_m werden die Ausgänge SOH, k des physikalischen Alterungsmodells 5 und des Korrekturmodells 6, welches vorzugsweise als Gauß-Prozess-Modell ausgeführt ist, miteinander beaufschlagt. Insbesondere können diese in einem Summierblock 7 addiert oder multipliziert (nicht gezeigt) werden, um den korrigierten Alterungszustand SOH_m zu einem aktuellen Auswertungszeitraum zu erhalten
Andere Ausgestaltungen des datenbasierten Alterungszustandsmodells sind ebenfalls möglich, beispielsweise kann das datenbasierte Alterungszustandsmodell als nicht-hybrides, rein datenbasiertes Modell basierend auf einem probabilistischen oder einem auf künstlicher Intelligenz basierendem Regressionsmodell, insbesondere einem Gauß-Prozess-Modell, oder einem Bayesschen neuronalen Netz ausgebildet sein. Dieses ist trainiert, um einen Alterungszustand SOH aus einem Betriebsmerkmalspunkt, der durch aktuelle Betriebsmerkmale M eines aktuellen Auswertungszeitraums bestimmt ist, bereitzustellen, wobei die Betriebsmerkmale in einem Merkmalsextraktionsblock 8 basierend auf den Zeitreihen der Betriebsgrößen F ermittelt werden.

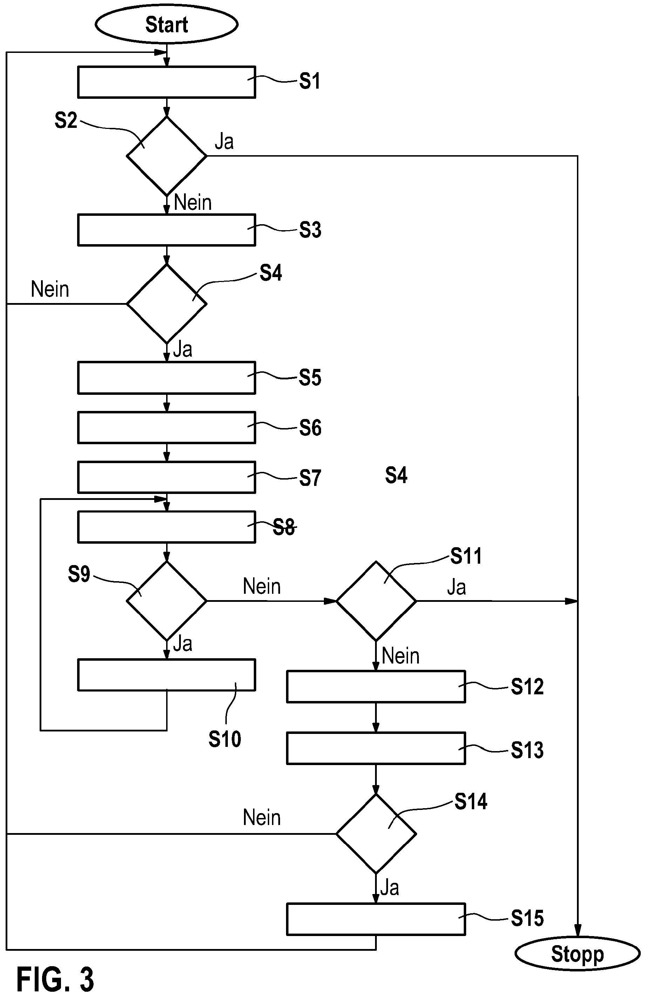

Figur 3 zeigt ein Flussdiagramm zur Veranschaulichung eines Verfahrens zum Ermitteln einer Maßnahme zur Verlängerung der Lebensdauer der Fahrzeugbatterie, insbesondere von Maßnahmen, die helfen, bei einer bereits gestressten Fahrzeugbatterie 41 eine vorgegebene Soll-Lebensdauer zu erreichen.

Das Verfahren kann in der Zentraleinheit 2 für jedes der Kraftfahrzeugs 4 der Flotte 3 ausgeführt werden. Alternativ kann das Verfahren auch in den Kraftfahrzeugen 4 durchgeführt werden, wenn das Alterungszustandsmodell in den Kraftfahrzeugen 4 implementiert ist. Der Zentraleinheit 2 liegen dazu die Zeitreihen der Betriebsgrößen für jeden Auswertungszeitraum und entsprechende Verläufe der Alterungszustände der Fahrzeugbatterien 41 der Kraftfahrzeuge 4 vor. Alternativ kann das nachstehend beschriebene Verfahren auch in den Kraftfahrzeugen 4 durchgeführt werden, wenn ein entsprechendes Alterungszustandsmodell in dem Kraftfahrzeug vorgesehen ist.

In Schritt S1 werden für einen aktuellen Auswertungszeitraum die Betriebsgrößen F von einem bestimmten Fahrzeug 4 empfangen. Aus den in der Zentraleinheit 2 gespeicherten Zeitreihen der Betriebsgrößen F können Betriebsmerkmale extrahiert werden. Mit Hilfe des Alterungszustandsmodells kann so basierend auf den Betriebsmerkmalen und dem zuletzt ermittelten Alterungszustand der aktuelle Alterungszustand der Fahrzeugbatterie 41 ermittelt werden.

In Schritt S2 wird überprüft, ob ein Soll-Alterungszustand erreicht worden ist, der einem Ende der Lebensdauer der Fahrzeugbatterie 41 entspricht. Der Soll-Alterungszustand kann beispielsweise 80 % SOH-C betragen. Diese Angabe entspricht einer Kapazität der Fahrzeugbatterie 41 von 80 % der zum Inbetriebnahmezeitpunkt (Begin of Life) verfügbaren Batteriekapazität. Wird in dem aktuellen Zeitschritt erkannt, dass der aktuelle Alterungszustand eine höhere Restkapazität der Fahrzeugbatterie 41 angibt (Alternative: Nein), so wird das Verfahren mit Schritt S3 fortgesetzt. Wird in Schritt S2 festgestellt, dass der Soll-Alterungszustand erreicht oder unterschritten ist (Alternative: Ja), so wird das Verfahren beendet.

In Schritt S3 wird der Verlauf des Alterungszustands für zukünftige Auswertungszeiträume prädiziert. Dies kann mithilfe des datenbasierten Alterungszustandsmodells, z. B. durch Extrapolation der Betriebsgrößen und/oder der Betriebsmerkmale oder anderes Prognostizieren der Entwicklung der Betriebsmerkmale, und sukzessive Berechnung des Alterungszustands für nachfolgende künftige Auswertungszeiträume jeweils basierend auf einem zu einem vorangehenden Zeitschritt erreichten Alterungszustand durchgeführt werden. Weiterhin können Umweltgrößen für künftige Auswertungszeiträume abhängig von der Jahreszeit ebenfalls berücksichtigt werden, insbesondere bezüglich der Prognosen hinsichtlich der Batterietemperatur.

Andere Verfahren zur Prädiktion des Verlaufs des Alterungszustands basierend auf den zeitlichen Verläufen der Betriebsgrößen, wie z. B. durch Vergleich des zurückliegenden Verlaufs des Alterungszustands einer Fahrzeugbatterie mit in der Zentraleinheit 2 aufgezeichneten Alterungsverläufen von anderen Fahrzeugen 4 der Flotte 3, deren Fahrzeugbatterien 41 das Lebensdauerende bereits erreicht haben, sind ebenfalls denkbar.

Die Prädiktion kann beispielsweise bis zum Erreichen von Kriterien durchgeführt werden, die ein Ende der Lebensdauer der Fahrzeugbatterie 41 angeben. Beispielsweise kann nach jeder Berechnung eines Alterungszustands für einen nachfolgenden Auswertungszeitraum mithilfe eines Kriteriums überprüft werden, ob eine Batteriekapazität größer 80 % der anfänglichen Batteriekapazität vorhanden ist.

In Schritt S4 wird anhand des prädizierten Verlaufs des Alterungszustands überprüft, ob der vorgegebene Soll-Alterungszustand vor Ablauf einer vorgegebenen Mindestlebensdauer der Fahrzeugbatterie 41 erreicht wird. Die Mindestlebensdauer gibt in Verbindung mit dem Soll-Alterungszustand einen Zeitraum an, in dem die Fahrzeugbatterie 41 sinnvoll genutzt werden kann. Beispielsweise entspricht eine gängige Vorgabe einem Erreichen eines Soll-Alterungszustands von 80 % der Anfangskapazität nach frühestens acht Jahren. Diese Überprüfung kann eine Ermittlung der Gesamtlebensdauer der Fahrzeugbatterie 41 aus der Summe des aktuellen Alters der Fahrzeugbatterie 41 und der Anzahl der Auswertungszeiträume bis zum Erreichen des Soll-Alterungszustands ermittelt werden.

Wenn in Schritt S4 festgestellt wird, dass die Mindestlebensdauer nicht erreicht wird (Alternative: Ja), so wird das Verfahren mit Schritt S5 fortgesetzt, anderenfalls (Alternative: Nein) wird zu Schritt S1 zurückgesprungen und keine Handlungsempfehlung an den Fahrer ist notwendig.

In Schritt S5 werden die Stressfaktoren, die eine Alterung der Fahrzeugbatterie 41 bewirken, durch eine Analyse des Alterungszustandsmodells identifiziert.

Es kann mit dem Alterungszustandsmodell bewertet werden, welche Auswirkungen die Stressfaktoren auf die spezielle Batteriealterung hat. Dies erlaubt die Formulierung eines Optimierungsproblems, um Nutzmuster bzgl. Ihrer Stressfaktoren anzupassen bzw. zu optimieren, dass ein gewünschtes Alterungsverhalten erreicht wird. Derartige Stressfaktoren können beispielsweise die Anzahl von Schnellladezyklen, hohe Stromflüsse bei hohen Temperaturen, die Anzahl von Lade- und Entladezyklen bei sehr hohen Ladezuständen (> 80 % des maximalen Ladezustands) oder bei sehr niedrigen Ladezuständen (< 20 % des maximalen Ladezustands) und dergleichen sein. Diese Stressfaktoren können sich durch die Betrachtung eines oder mehrerer der Betriebsmerkmale, die von den Betriebsgrößen abgeleitet werden, ergeben.

Stressfaktoren sind aus Labormessungen vor der Inbetriebnahme bekannt. Aber auch aus Flottendaten auftretenden Auffälligkeiten bzgl. verstärkter Alterungserscheinungen können anhand der Betriebsmerkmale als entsprechende Stressfaktoren erkannt werden. Stressfaktoren ergeben sich direkt aus dem Alterungszustandsmodell, also z. B. den Betriebsmerkmalen für das Korrekturmodell (Gaußprozess) im hybriden Alterungszustandsmodell.

Die Stressfaktoren zeichnen sich in der Regel durch eines der Betriebsmerkmale aus. Mit anderen Worten sind Stressfaktoren Betriebsmerkmale, welche die Batterie verstärkt altern lassen.

Im Schritt S6 wird der einflussreichste der Stressfaktoren ermittelt. Dies kann mithilfe des Alterungsmodells durch Lösen eines Optimierungsproblems erfolgen, also beispielsweise durch eine Ableitung des Verlaufs des Alterungszustands nach jedem der die Stressfaktoren bestimmenden Betriebsmerkmale. Je größer der Quotient aus der zeitlichen Änderung des Alterungszustands und der zeitlichen Änderung des einen Stressfaktor bestimmenden Betriebsmerkmals ist, desto größer ist der Einfluss des der jeweiligen Betriebsgröße zugeordneten Stressfaktors. Bei der Auswahl der Stressfaktoren kann vorgesehen sein, dass nur diejenigen Stressfaktoren berücksichtigt werden, die in einer Akzeptanzmenge von Stressfaktoren vorhanden sind. Wie weiter unten ausführlicher beschrieben, können Stressfaktoren von der Akzeptanzmenge zur Auswahl des einflussreichsten Stressfaktors ausgenommen werden, wenn die diesen zugeordnete Maßnahme durch das Verhalten des Fahrers einmalig, mehrfach oder nur teilweise berücksichtigt worden sind.

Der Einfluss eines Stressfaktors auf die Alterung der Fahrzeugbatterie 41 kann mit dem Alterungszustandsmodell bewertet werden. Alternativ kann bei bekannten Stressfaktoren aus Labormessungen die Stärke des Einflusses auf das Alterungsverhalten bestimmt/ermittelt werden. Dies kann über Gewichtungsfaktoren oder Klassifizierungen (stark/mittel/schwach) erfolgen.

Beispielsweise kann ein Stressfaktor in einem häufigen Schnellladen bestehen. Der Einfluss dieses Stressfaktors auf die Alterung der Fahrzeugbatterie 41 kann modellbasiert z. B. mit einem hybriden Alterungsmodell bestimmt werden. Alternativ kann der Einfluss dieses Stressfaktors auf die Alterung der Fahrzeugbatterie 41 durch einen Quotienten der Änderung des Alterungszustands innerhalb eines Auswertungszeitraums und einer Häufigkeit des Schnellladens innerhalb des Auswertungszeitraums bestimmt werden.

In Schritt S7 kann für den bestimmten einflussreichsten Stressfaktor ein Testwert eines dem betreffenden Stressfaktor zugeordneten stressmaximierenden Betriebsmerkmals zugeordnet werden, das vorzugsweise einem bestmöglichen Wert des betreffenden stressmaximierenden Betriebsmerkmals entspricht. Der bestmögliche Wert des betreffenden stressmaximierenden Betriebsmerkmals entspricht einem Wert, der bezüglich des Betriebsmerkmals für die Alterung der Fahrzeugbatterie am schonendsten ist.

Nun wird in Schritt S8 entsprechend der Vorgehensweise in den Schritten S1 und S2 eine Prädiktion des Verlaufs des Alterungszustands unter der Annahme, dass unter Beibehaltung und Fortschreibung der übrigen Betriebsmerkmale für künftige Auswertungszeiträume das stressmaximierende Betriebsmerkmal den Testwert annimmt, vorgenommen und die Zeitdauer ermittelt, zu der der Soll-Alterungszustand erreicht bzw. unterschritten wird.

Die sich daraus ergebende Restlebensdauer bzw. Gesamtlebensdauer wird in Schritt S9 dahingehend überprüft, ob die Mindestlebensdauer der Fahrzeugbatterie 41 erreicht wird. Wird in Schritt S9 festgestellt, dass die Mindestlebensdauer nicht mehr erreicht wird (Alternative: Nein), so wird das Verfahren mit Schritt S11 fortgesetzt, andernfalls (Alternative: Ja) wird in Schritt S10 der Testwert inkrementell durch Optimierung der Nutzmuster und damit implizit der Stressfaktoren mithilfe des Alterungsmodells in eine Richtung geändert, durch die die Fahrzeugbatterie 41 eine höhere Alterungsbelastung erfährt, und das Verfahren mit Schritt S8 fortgesetzt. Die Inkremente sind bei Häufigkeiten ganzzahlig und bei elektrischen Größen in ihrem Betrag hinreichend klein gewählt, so dass eine für eine Empfehlung einer Maßnahme ausreichend genaue Bestimmung des Maßes des stressmaximierenden Betriebsmerkmals möglich ist.

In Schritt S11 wird überprüft, ob der Testwert dem anfänglich angenommenen Testwert entspricht. Ist dies der Fall (Alternative: Ja), so wird festgestellt, dass die Mindestlebensdauer der Fahrzeugbatterie 41 nicht mehr erreicht werden kann, und das Verfahren beendet. Andernfalls (Alternative: Nein) wird das Verfahren mit Schritt S12 fortgesetzt.

In Schritt S12 entspricht der Testwert einem Wert, bei dem die Mindestlebensdauer der Fahrzeugbatterie 41 durch entsprechende Wahl des betreffenden stressmaximierenden Betriebsmerkmals gerade nicht mehr erreicht. Daher wird der Wert des stressmaximierenden Betriebsmerkmals entsprechend in Richtung einer geringeren Belastung der Fahrzeugbatterie 41 inkrementell (entsprechend den oben gewählten Betrag des Inkrements) geändert, um einen Zielwert des Betriebsmerkmals zu erhalten.

In Schritt S13 wird nun dem betreffenden stressmaximierenden Betriebsmerkmal und seinem Zielwert mithilfe eines Zuordnungsmodells eine Maßnahme zugeordnet und diese an einen Fahrer des Kraftfahrzeugs signalisiert.

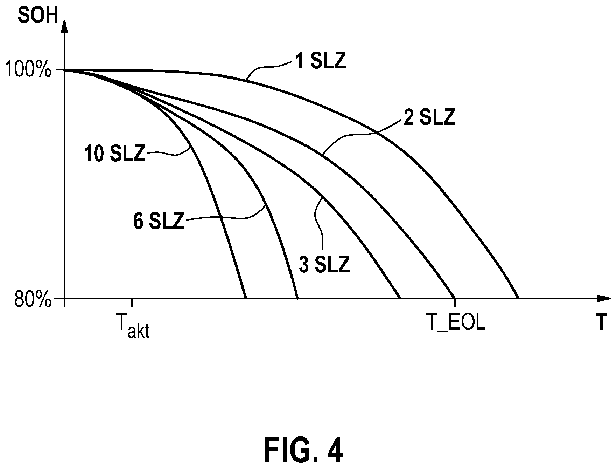

Auf diese Weise ist es möglich, einem Fahrer stets die einflussreichste Maßnahme vorzuschlagen, um die Lebensdauer der Fahrzeugbatterie 41 zu verlängern. Dadurch ist es beispielsweise möglich, dass einem Fahrer, der seine Fahrzeugbatterie 41 häufig an einer Schnellladestation bei hoher Batterietemperatur auflädt, als Maßnahme eine Reduzierung der Schnellladevorgänge vorgeschlagen wird, und nicht eine Leistungsreduzierung durch eine Strombegrenzung, da dieser vornehmlich im Stadtverkehr unterwegs ist. Beispielsweise ist in Figur 4 der Verlauf des Alterungszustands SOH der Fahrzeugbatterie 41 als Stressfaktor der Schnellladehäufigkeit SLZ beispielhaft für verschiedene Häufigkeiten dargestellt. Hierbei wird die Vorgehensweise zur Ermittlung der Anzahl der notwendigen Schnellladezyklen SLZ ausgehend von einem erreichten SOH-Wert zu einem aktuellen Zeitpunkt Tₐₖₜ durch den steigenden Testwert für die Schnellladehäufigkeit dargestellt, um die vorgegebene Mindestlebensdauer zu erreichen. Hier wäre eine Reduzierung von zehn Schnellladezyklen auf zwei Schnellladezyklen pro Monat eine Handlungsempfehlung an den Fahrer, da dadurch die Mindestlebensdauer erreicht werden kann.

Im umgekehrten Fall, bei dem ein Fahrer vornehmlich auf Autobahnen bei hohen Geschwindigkeiten und hohen Batterietemperaturen fährt und dadurch die Fahrzeugbatterie 41 schneller altert, kann diesem eine Leistungsreduzierung empfohlen werden, da dies den größten Einflussfaktor auf die Batteriealterung darstellt, und nicht die Reduzierung der von ihm selten vorgenommenen Schnellladezyklen.

Während der Stressfaktor ein Betriebsmerkmal oder eine davon abgeleitete Größe, wie beispielsweise ein Betriebsmerkmalsgradient bzw. ein Betriebsgrößenintegral, betreffen kann, können die Maßnahmen entweder direkt auf die Änderung des Betriebsmerkmals einwirken und somit die Alterung der Fahrzeugbatterie aufgrund des entsprechenden Stressfaktors reduzieren. So kann beispielsweise die Häufigkeit von Schnellladevorgängen direkt durch den Maßnahmenvorschlag einer Reduzierung der Anzahl von Schnellladezyklen zugeordnet werden. Wird jedoch als Stressfaktor festgestellt, dass das Laden der Fahrzeugbatterie in der Regel bei sehr hohen Temperaturen erfolgt, so kann als empfohlene Maßnahme eine Änderung der Ladezeit auf Zeiträume während der Nacht vorgeschlagen werden.

Anstelle der Signalisierung einer Maßnahme an den Fahrer können ggfs. die Maßnahmen automatisch im Fahrzeug umgesetzt werden, beispielsweise durch Begrenzen der Stromaufnahme bei einem Ladevorgang oder Begrenzen des maximalen Entladestroms.

In Schritt S14 kann für zurückliegende Auswertungszeiträume und zurückliegende Maßnahmen ermittelt werden, ob der Fahrer die jeweils in Schritt S13 vorgeschlagene Maßnahme nicht oder nur teilweise berücksichtigt hat. Dies kann durch Vergleich des zur vorgeschlagenen Maßnahme zugeordneten Betriebsmerkmals und dem dazu ermittelten Zielwert des Betriebsmerkmals erfolgen. Wird in nachfolgenden Auswertungszeiträumen einmalig oder mehrfach festgestellt, dass die Signalisierung der Maßnahme zur Anpassung des Betriebsmerkmals in Richtung des entsprechenden Zielwerts nicht zu einem Erreichen des Zielwerts geführt hat (Alternative: Ja), so kann in Schritt S15 die Akzeptanzmenge um den dem Betriebsmerkmal zugeordneten Stressfaktor reduziert werden, so dass die entsprechende Maßnahme dem Fahrer nicht mehr vorgeschlagen wird. Andernfalls wird das Verfahren mit Schritt S1 fortgesetzt.

Es wird durch die obige Vorgehensweise insbesondere erreicht, dass einem Fahrer, der die vorgeschlagene Maßnahme nur teilweise berücksichtigt, d. h. wie im obigen Beispiel die Schnellladezyklen nicht auf zwei, sondern lediglich auf vier Schnellladezyklen SLZ pro Monat reduziert, eine weitere Maßnahme an die Hand gegeben wird, damit das Ziel des Erreichens der Mindestlebensdauer erreicht werden kann. Somit kann eine Kombination aus mehreren Maßnahmen ebenfalls zum Ziel führen, wobei die Fahrerakzeptanz für die verschiedenen Maßnahmen berücksichtigt wird.

Insbesondere kann erst nachdem mehrfach festgestellt worden ist, dass die Signalisierung der Maßnahme zur Anpassung des Betriebsmerkmals in Richtung des entsprechenden Zielwerts nicht zu einem Erreichen des Zielwerts geführt hat, die Akzeptanzmenge um den dem Betriebsmerkmal zugeordneten Stressfaktor reduziert werden. Wenn der Fahrer eine Empfehlung, z. B. "Schnellladezyklen reduzieren", nur teilweise befolgt, so kann gegebenenfalls eine weitere gleichlautende Empfehlung an den Fahrer für den nächsten Zeitraum, die Anzahl an Schnellladezyklen noch weiter zu reduzieren, den Fahrer tatsächlich motivieren, batteriebewusster zu handeln. Eine weitere Empfehlung an den Fahrer für den nächsten Zeitraum, die Anzahl an Schnellladezyklen noch weiter zu reduzieren, wird dagegen mit hoher Wahrscheinlichkeit vom Fahrer nicht akzeptiert werden, wenn er zuvor die Empfehlung vollständig ignoriert hat. Somit kann als nächste Maßnahme ein auf den nächst- bzw. zweiteinflussreichsten Stressfaktor basierender Vorschlag bereitgestellt werden, so dass der Fahrer im Rahmen seines Akzeptanzbereichs die entsprechenden Maßnahmen, die den größten Einfluss auf die Verlängerung der Lebensdauer der Fahrzeugbatterie haben, umsetzen kann.

## Patentansprüche

1. Computerimplementiertes Verfahren zum Betreiben eines Systems mit einer batteriebetriebenen Maschine (4) mit einer Batterie (41), mit folgenden Schritten:
- kontinuierliches Bereitstellen (S1) von Betriebsgrößen der Batterie (41);
- Ermitteln von Betriebsmerkmalen (M) für einen aktuellen Auswertungszeitraum abhängig von den Verläufen der bereitgestellten Betriebsgrößen (F), wobei die Betriebsmerkmale (M) eine Nutzung der Batterie (41) in dem Auswertungszeitraum charakterisieren;
- Ermitteln (S5) eines oder mehrerer stressmaximierender Betriebsmerkmale (M), die einem Stressfaktor für die Batterie (41) zugeordnet sind, der den stärksten Einfluss auf die Alterung der Batterie (41) hat, mithilfe eines Alterungszustandsmodells;
- Signalisieren (S13) einer Maßnahme in der Maschine (4) abhängig von dem ermittelten Stressfaktor,
wobei einem Nutzer die Maßnahme vorgeschlagen wird, wobei der Maßnahmenvorschlag unter Berücksichtigung der typischen Nutzmuster des Nutzers entsprechend einer Auswahl desjenigen Stressfaktors vorgeschlagen wird, dessen Änderung den größten Einfluss auf die Änderung eines Alterungszustands hat.

2. Verfahren nach Anspruch 1, wobei das Ermitteln der Betriebsmerkmale (M) und/oder das Ermitteln des einen oder der mehreren stressmaximierenden Betriebsmerkmale (M) maschinenextern in einer Zentraleinheit (2) durchgeführt wird, in der das Alterungszustandsmodell implementiert ist, das insbesondere basierend auf Flottendaten einer Vielzahl von Maschinen (4) erstellt ist.

3. Verfahren nach Anspruch 1 oder 2, wobei ein Zielwert für das eine oder die mehreren stressmaximierenden Betriebsmerkmale (M) als ein Wert für das eine oder die mehreren stressmaximierenden Betriebsmerkmale (M) ermittelt wird, bei dem bei ansonsten gleichbleibendem Verlauf der Betriebsmerkmale (M) die Alterung der Batterie (41) gerade noch das Erreichen einer vorgegebenen Mindestlebensdauer der Batterie (41) gewährleistet.

4. Verfahren nach Anspruch 3, wobei die zu signalisierende Maßnahme abhängig von dem ermittelten einen oder den mehreren stressmaximierenden Betriebsmerkmalen (M) und dem jeweiligen Zielwert zugeordnet wird.

5. Verfahren nach einem der Ansprüche 1 bis 4, wobei das Ermitteln des einen oder der mehreren stressmaximierenden Betriebsmerkmale nur diejenigen Betriebsmerkmale (M) berücksichtigt, die Maßnahmen aus einer Akzeptanzmenge von Maßnahmen zugeordnet sind, wobei signalisierte Maßnahmen, die einmalig oder mehrmalig nicht von einem Nutzer umgesetzt worden sind, aus der Akzeptanzmenge von Maßnahmen entfernt werden.

6. Verfahren nach einem der Ansprüche 1 bis 5, wobei das Ermitteln des einen oder der mehreren stressmaximierenden Betriebsmerkmale durchgeführt wird, indem mithilfe des Alterungszustandsmodells ein normierter Gradient des Alterungszustands über den Betriebsmerkmalen (M) ermittelt wird, wobei dasjenige bzw. diejenigen Betriebsmerkmale (M) als stressmaximierende Betriebsmerkmale ausgewählt werden, für die der normierte Gradient am höchsten ist.

7. Verfahren nach einem der Ansprüche 1 bis 6, wobei die Betriebsgrößen (F) der Batterie einer bestimmten Maschine (4) an eine maschinenexterne Zentraleinheit (2) übermittelt werden, wobei die Schritte des Ermittelns von Betriebsmerkmalen (M) für einen aktuellen Auswertungszeitraum und des Ermittelns des einen oder der mehreren stressmaximierenden Betriebsmerkmale in der Zentraleinheit (2) ausgeführt werden, wobei das eine oder die mehreren stressmaximierenden Betriebsmerkmale (M) an die bestimmte Maschine (4) übermittelt werden.

8. Verfahren nach einem der Ansprüche 1 bis 7, wobei die batteriebetriebene Maschine (4) einem Kraftfahrzeug, einem Pedelec, einem Fluggerät, insbesondere einer Drohne, einer Werkzeugmaschine, einem Gerät der Unterhaltungselektronik, wie ein Mobiltelefon, einem autonomen Roboter und/oder einem Haushaltsgerät entspricht.

9. Vorrichtung zum Betreiben einer batteriebetriebenen Maschine (4) mit einer Batterie (41), wobei die Vorrichtung ausgebildet ist zum:
- kontinuierliches Bereitstellen von Betriebsgrößen der Batterie (41);
- Ermitteln von Betriebsmerkmalen für einen aktuellen Auswertungszeitraum abhängig von den Verläufen der bereitgestellten Betriebsgrößen, wobei die Betriebsmerkmale eine Nutzung der Batterie (41) in dem Auswertungszeitraum charakterisieren;
- Ermitteln eines oder mehrerer stressmaximierender Betriebsmerkmale, die einem Stressfaktor für die Batterie (41) zugeordnet sind, der den stärksten Einfluss auf die Alterung der Batterie (41) hat, mithilfe eines Alterungszustandsmodells;
- Signalisieren einer Maßnahme in der Maschine (4) abhängig von dem ermittelten Stressfaktor;
wobei einem Nutzer die Maßnahme vorgeschlagen wird, wobei der Maßnahmenvorschlag unter Berücksichtigung der typischen Nutzmuster des Nutzers entsprechend einer Auswahl desjenigen Stressfaktors vorgeschlagen wird, dessen Änderung den größten Einfluss auf die Änderung eines Alterungszustands hat.

10. System mit einer Zentraleinheit und einer Vielzahl von Maschinen (4), wobei jede Maschine (4) eine Vorrichtung nach Anspruch 9 umfasst.

11. System nach Anspruch 10, wobei die Zentraleinheit (2) ausgebildet ist, um das Ermitteln von Betriebsmerkmalen (M) und das Ermitteln des einen oder der mehreren stressmaximierenden Betriebsmerkmale (M) auszuführen.

12. Computerprogrammprodukt umfassend Befehle, die bei der Ausführung des Programms durch mindestens eine Datenverarbeitungseinrichtung diese veranlassen, die Schritte des Verfahrens nach einem der Ansprüche 1 bis 8 auszuführen.

13. Maschinenlesbares Speichermedium, umfassend Befehle, die bei der Ausführung durch mindestens eine Datenverarbeitungseinrichtung diese veranlassen, die Schritte des Verfahrens nach einem der Ansprüche 1 bis 8 auszuführen.

## Claims

1. Computer-implemented method for operating a system having a battery-operated machine (4) having a battery (41), having the following steps:
- continuously providing (S1) operating variables of the battery (41);
- ascertaining operating features (M) for a current evaluation period depending on the characteristics of the provided operating variables (F), wherein the operating features (M) characterize a use of the battery (41) in the evaluation period;
- ascertaining (S5) one or multiple stress-maximizing operating features (M) that are associated with a stress factor for the battery (41), said stress factor having the greatest influence on the ageing of the battery (41), using a state of health model;
- signalling (S13) a measure in the machine (4) depending on the ascertained stress factor,
wherein the measure is proposed to a user, wherein the proposed measure is proposed taking into account the typical useful patterns of the user according to a selection of the stress factor whose change has the greatest influence on the change in a state of health.

2. Method according to Claim 1, wherein the operating features (M) and/or the one or the multiple stress-maximizing operating features (M) are ascertained external to the machine in a central processing unit (2) in which the state of health model, which is produced in particular based on fleet data of a plurality of machines (4), is implemented.

3. Method according to Claim 1 or 2, wherein a target value for the one or the multiple stress-maximizing operating features (M) is ascertained as a value for the one or the multiple stress-maximizing operating features (M) at which the ageing of the battery (41) currently still ensures the reaching of a prescribed minimum lifetime of the battery (41) given an otherwise constant characteristic of the operating features (M).

4. Method according to Claim 3, wherein the measure that is to be signalled is assigned depending on the ascertained one or the multiple stress-maximizing operating features (M) and the respective target value.

5. Method according to one of Claims 1 to 4, wherein the ascertaining of the one or the multiple stress-maximizing operating features takes into account only those operating features (M) that are assigned to measures from an acceptance set of measures, wherein signalled measures that have not been implemented by a user once or several times are removed from the acceptance set of measures.

6. Method according to one of Claims 1 to 5, wherein the one or the multiple stress-maximizing operating features is or are ascertained by virtue of a standardized gradient of the state of health against the operating features (M) being ascertained using the state of health model, wherein that or those operating feature or features (M) for which the standardized gradient is highest is or are selected as stress-maximizing operating features.

7. Method according to one of Claims 1 to 6, wherein the operating variables (F) of the battery of a specific machine (4) are transmitted to a central processing unit (2) external to the machine, wherein the steps of ascertaining operating features (M) for a current evaluation period and ascertaining the one or the multiple stress-maximizing operating features are executed in the central processing unit (2), wherein the one or the multiple stress-maximizing operating features (M) are transmitted to the specific machine (4).

8. Method according to one of Claims 1 to 7, wherein the battery-operated machine (4) corresponds to a motor vehicle, a pedelec, an aircraft, in particular a drone, a machine tool, a consumer electronics device, such as a mobile phone, an autonomous robot and/or a domestic appliance.

9. Apparatus for operating a battery-operated machine (4) having a battery (41), wherein the apparatus is designed to:
- continuously provide operating variables of the battery (41);
- ascertain operating features for a current evaluation period depending on the characteristics of the provided operating variables, wherein the operating features characterize a use of the battery (41) in the evaluation period;
- ascertain one or multiple stress-maximizing operating features that are associated with a stress factor for the battery (41), said stress factor having the greatest influence on the ageing of the battery (41), using a state of health model;
- signal a measure in the machine (4) depending on the ascertained stress factor;
wherein the measure is proposed to a user, wherein the proposed measure is proposed taking into account the typical useful patterns of the user according to a selection of the stress factor whose change has the greatest influence on the change in a state of health.

10. System having a central processing unit and a plurality of machines (4), wherein each machine (4) comprises an apparatus according to Claim 9.

11. System according to Claim 10, wherein the central processing unit (2) is designed to ascertain operating features (M) and to ascertain the one or the multiple stress-maximizing operating features (M).

12. Computer program product comprising instructions that, when the program is executed by at least one data processing device, cause said data processing device to perform the steps of the method according to one of Claims 1 to 8.

13. Machine-readable storage medium, comprising instructions that, when executed by at least one data processing device, cause said data processing device to perform the steps of the method according to one of Claims 1 to 8.

## Revendications

1. Procédé mis en œuvre par ordinateur pour le fonctionnement d'un système comprenant une machine fonctionnant sur batterie (4) comprenant une batterie (41), comportant les étapes suivantes :
- fournir en continu (S1) des grandeurs de fonctionnement de la batterie (41) ;
- déterminer des caractéristiques de fonctionnement (M) pour une période d'évaluation actuelle en fonction de l'évolution des grandeurs de fonctionnement fournies (F), les caractéristiques de fonctionnement (M) caractérisant une utilisation de la batterie (41) pendant la période d'évaluation ;
- déterminer (S5) une ou plusieurs caractéristiques de fonctionnement (M) maximisant le stress, lesquelles sont associées à un facteur de stress pour la batterie (41), qui a le plus d'influence sur le vieillissement de la batterie (41), à l'aide d'un modèle d'état de vieillissement ;
- signaler (S13) une mesure prise dans la machine (4) en fonction du facteur de stress déterminé,
la mesure étant proposée à un utilisateur, la proposition de mesure étant fournie en tenant compte des modes d'utilisation typiques de l'utilisateur en fonction d'une sélection du facteur de stress dont la variation a le plus d'influence sur la variation d'un état de vieillissement.

2. Procédé selon la revendication 1, dans lequel la détermination des caractéristiques de fonctionnement (M) et/ou la détermination d'une ou de plusieurs caractéristiques de fonctionnement (M) maximisant le stress est effectuée à l'extérieur de la machine dans une unité centrale (2) dans laquelle est mis en œuvre le modèle d'état de vieillissement, qui est créé en particulier sur la base de données de flotte d'une pluralité de machines (4).

3. Procédé selon la revendication 1 ou 2, dans lequel une valeur cible pour la ou les caractéristiques de fonctionnement maximisant le stress (M) est déterminée en tant que valeur pour la ou les caractéristiques de fonctionnement maximisant le stress (M), à laquelle, pour une évolution par ailleurs inchangée des caractéristiques de fonctionnement (M), le vieillissement de la batterie (41) garantit de justesse que la durée de vie minimale prédéterminée de la batterie (41) soit atteinte.

4. Procédé selon la revendication 3, dans lequel la mesure à signaler est associée en fonction de la ou des caractéristiques de fonctionnement maximisant le stress (M) déterminées et de la valeur cible respective.

5. Procédé selon l'une quelconque des revendications 1 à 4, dans lequel la détermination de la ou des caractéristiques de fonctionnement maximisant le stress ne prend en compte que les caractéristiques de fonctionnement (M) auxquelles sont associées des mesures provenant d'un ensemble de mesures acceptées, les mesures signalées qui n'ont pas été mises en œuvre une ou plusieurs fois par un utilisateur étant supprimées de l'ensemble de mesures acceptées.

6. Procédé selon l'une quelconque des revendications 1 à 5, dans lequel la détermination de la ou des caractéristiques de fonctionnement maximisant le stress est effectuée en déterminant, à l'aide du modèle d'état de vieillissement, un gradient normalisé de l'état de vieillissement par rapport aux caractéristiques de fonctionnement (M), la ou les caractéristiques de fonctionnement (M) pour lesquelles le gradient normalisé est le plus élevé étant sélectionnées comme caractéristiques de fonctionnement maximisant le stress.

7. Procédé selon l'une quelconque des revendications 1 à 6, dans lequel les grandeurs de fonctionnement (F) de la batterie d'une machine (4) déterminée sont transmises à une unité centrale externe (2), les étapes de détermination de caractéristiques de fonctionnement (M) pour une période d'évaluation actuelle et de détermination d'une ou de plusieurs caractéristiques de fonctionnement maximisant le stress dans l'unité centrale (2) étant réalisées, une ou plusieurs caractéristiques de fonctionnement maximisant le stress (M) étant transmises à la machine (4) déterminée.

8. Procédé selon l'une quelconque des revendications 1 à 7, dans lequel la machine fonctionnant sur batterie (4) est un véhicule automobile, un pedelec, un aéronef, en particulier un drone, une machine-outil, un appareil électronique grand public tel qu'un téléphone mobile, un robot autonome et/ou un appareil électroménager.

9. Dispositif destiné au fonctionnement d'une machine fonctionnant sur batterie (4) comprenant une batterie (41), le dispositif étant conçu pour :
- fournir en continu des grandeurs de fonctionnement de la batterie (41) ;
- déterminer des caractéristiques de fonctionnement pour une période d'évaluation actuelle en fonction de l'évolution des grandeurs de fonctionnement fournies, les caractéristiques de fonctionnement caractérisant une utilisation de la batterie (41) pendant la période d'évaluation ;
- déterminer une ou plusieurs caractéristiques de fonctionnement maximisant le stress, lesquelles sont associées à un facteur de stress pour la batterie (41), qui a le plus d'influence sur le vieillissement de la batterie (41), à l'aide d'un modèle d'état de vieillissement ;
- signaler une mesure prise dans la machine (4) en fonction du facteur de stress déterminé ;
la mesure étant proposée à un utilisateur, la proposition de mesure étant fournie en tenant compte des modes d'utilisation typiques de l'utilisateur en fonction d'une sélection du facteur de stress dont la variation a le plus d'influence sur la variation d'un état de vieillissement.

10. Système comprenant une unité centrale et une pluralité de machines (4), dans lequel chaque machine (4) comprend un dispositif selon la revendication 9.

11. Système selon la revendication 10, dans lequel l'unité centrale (2) est conçue pour effectuer la détermination de caractéristiques de fonctionnement (M) et la détermination d'une ou de plusieurs caractéristiques de fonctionnement maximisant le stress (M).

12. Produit de programme informatique, comprenant des instructions qui, lors de l'exécution du programme par au moins un dispositif de traitement de données, amènent celui-ci à exécuter les étapes du procédé selon l'une quelconque des revendications 1 à 8.

13. Support de stockage lisible par machine, comprenant des instructions qui, lorsqu'elles sont exécutées par au moins un dispositif de traitement de données, amènent celui-ci à exécuter les étapes du procédé selon l'une quelconque des revendications 1 à 8.
